# FASCICULE DE BREVET EUROPEEN

(11) **EP 2 833 204 B1**
(45) Date de publication et mention de la délivrance du brevet: **14.06.2017**
(21) Numéro de dépôt: 13179155.0
(22) Date de dépôt: 02.08.2013
(51) Int. Cl.: G03F 7/40, G03F 7/42, B81C 99/00, G03F 7/00, G04B 15/14, C25D 1/00

(54) **Procede de traitement d'une couche de resine photosensible et procede de fabrication d'un composant metallique**
Behandlungsverfahren einer lichtsensiblen Harzschicht, und Herstellungsverfahren einer Metallkomponente
Method for treating a layer of photosensitive resin and method for manufacturing a metal component

(43) Date de publication de la demande: 04.02.2015
(73) Titulaire: ROLEX SA, 1211 Genève 26 (CH)
(72) Inventeur: Calame, Florian, 1066 Epalinges (CH)
(74) Mandataire: Moinas & Savoye SARL

(56) Documents cités:
- EP-A1- 1 835 339
- CH-A2- 704 086
- US-A- 5 529 681
- US-A1- 2010 170 871
- RAINER ENGELKE ET AL: "Investigations of SU-8 removal from metallic high aspect ratio microstructures with a novel plasma technique", MICROSYSTEM TECHNOLOGIES ; MICRO AND NANOSYSTEMS INFORMATION STORAGE AND PROCESSING SYSTEMS, SPRINGER, BERLIN, DE, vol. 14, no. 9-11, 29 janvier 2008 (2008-01-29), pages 1607-1612, XP019632856, ISSN: 1432-1858
- MAKIMURA TETSUYA ET AL: "Responses of polymers to laser plasma EUV light beyond ablation threshold and micromachining", DAMAGE TO VUV, EUV, AND X-RAY OPTICS III, SPIE, 1000 20TH ST. BELLINGHAM WA 98225-6705 USA, vol. 8077, no. 1, 5 mai 2011 (2011-05-05), pages 1-10, XP060013557, DOI: 10.1117/12.887615 [extrait le 1901-01-01]

## Description

La présente invention concerne un procédé de fabrication d'un composant métallique par une technique de photolithographie et dépôt galvanique.

Ce type de procédé est utilisé notamment pour la fabrication de composants métalliques à plusieurs niveaux, par exemple des pièces d'horlogerie (ancres, sautoirs, engrenages, etc.).

Le brevet EP2405300 décrit différents exemples de réalisation d'un procédé de fabrication d'une pièce métallique à au moins deux niveaux. Selon un exemple particulier de réalisation, le procédé comprend les étapes successives suivantes :
- déposer une première couche de résine photosensible sur un substrat recouvert d'une couche conductrice, cette première couche définissant un premier niveau ;
- obtenir un premier moule en réalisant une cavité dans la première couche de résine par photolithographie à l'aide d'un masque;
- déposer un métal ou un alliage dans le premier moule, par un dépôt galvanique amorcé par la couche conductrice, afin de former une couche métallique de premier niveau ;
- enlever complètement la résine restante de la première couche pour ne laisser sur le substrat que la couche métallique de premier niveau ;
- déposer une deuxième couche de résine sur le substrat, par exemple d'épaisseur plus importante que la couche métallique de premier niveau, puis, par photolithographie à l'aide d'un masque, former un espace creux délimité par la couche conductrice, les flancs de la couche métallique de premier niveau et des flancs de la deuxième couche de résine.

Cet espace creux constitue en définitive un deuxième moule dans lequel on peut déposer un métal ou alliage par un dépôt galvanique amorcé par la couche conductrice et former (après retrait de la résine et du substrat) un composant métallique ayant au moins deux niveaux imbriqués l'un dans l'autre. Également mentionné est le brevet EP1835339 A1 qui décrit un procédé de fabrication par technologie de type LIGA d'un composant métallique pour être utilisé dans l'industrie horlogère.

Les brevets US 5529681 A et US 2010/170871 A1 décrivent un procédé comprenant une étape de gravure d'une couche de résine photosensible par exposition et développement et retrait partiel de la résine.

R. Engelke et al. décrivent dans MICROSYSTEM TECHNOLOGIES; MICRO AND NANOSYSTEMS INFORMATION STORAGE AND PROCESSING SYSTEMS, Vol. 14, No. 9-11, 29 janvier 2008, pages 1607-1612, un procédé de photolithographie à rayonnement UV appliqué sur une couche de résine SU-8, ledit procédé comprenant une étape de retrait partiel de la résine photosensible en utilisant un plasma.

MAKIMURA TETSUYA ET AL divulguent dans SPIE, 1000 20TH ST. BELLINGHAM WA 98225-6705 USA, vol. 8077, no. 1, 5 mai 2011, pages 1-10, "Responses of polymers to laser plasma EUV light beyond ablation threshold and micromachining", DAMAGE TO VUV, EUV, AND X-RAY OPTICS III, un procédé de traitement d'une couche photosensible de PDMS consistant à exposer cette couche à un rayonnement plasma de type EUV au travers d'un masque afin d'y graver des ouvertures. Toutefois, le procédé décrit dans le brevet EP2405300 est consommateur en temps de fabrication.

La présente invention vient améliorer la situation.

A cet effet, on utilise un procédé de traitement d'une couche de résine photosensible, comprenant une étape de photolithographie ou de lithographie par faisceau d'électrons suivie d'une étape de développement, caractérisé en ce qu'il comprend une étape d'ablation partielle de résine, subséquente à l'étape de développement.

Par « couche de résine » on entend désigner une structure comportant de la résine et définissant une couche s'étendant soit directement sur un substrat, soit sur une couche métallique, ou plus généralement sur un matériau différent de la résine sur une partie au moins de la surface. Il est décrit ci-dessous de réaliser une ablation partielle, dans une partie de la couche de résine photosensible ayant déjà été soumise à des étapes de photolithographie et de développement, afin de produire une ouverture ou cavité dans la couche existante. Par ablation "partielle", on entend désigner le fait d'enlever de la résine dans une partie de la couche de résine de façon localisée, délimitée et sélective.

L'invention concerne un procédé de fabrication d'un composant métallique, comprenant les étapes de :
- dépôt d'une couche initiale de résine photosensible sur un substrat;
- photolithographie ou lithographie aux électrons de la couche initiale de résine;
- développement de la couche initiale de résine et obtention d'un moule ;
- dépôt, notamment par électrodéposition, d'un métal ou d'un alliage, dans le moule ;
caractérisé par le fait que l'étape de dépôt d'un métal ou alliage est suivie d'une étape d'ablation partielle de résine de la couche initiale, afin de former une cavité.

D'emblée, on notera que par le terme « métal » on entend désigner un élément, composé, ou alliage métallique.

Selon l'invention, suite à l'étape de dépôt de métal, la résine de la couche initiale n'est enlevée que partiellement, et non pas en totalité.

L'ablation partielle de la résine de la couche initiale garantit un bon maintien du métal déposé sur le substrat par la résine restante de la couche initiale. En effet, après une ablation complète de la résine de la couche initiale, par exemple par plasma, il existe un risque non négligeable de décollement de la couche métallique déposée, celle-ci devenant alors inutilisable pour la réalisation d'un deuxième niveau. L'ablation partielle limite grandement ce risque et procure donc de meilleurs résultats.

Grâce à l'invention, le substrat demeure également protégé par la résine restante de la couche initiale tout au long du procédé de fabrication. Les contraintes liées au maintien de la propreté du substrat sont donc grandement diminuées.

Dans un mode de réalisation particulier, l'ablation partielle s'effectue par voie physique ou physicochimique.

Par les termes « voie physique ou physicochimique », on entend désigner une technique d'ablation de la résine qui met en jeu une action mécanique agissant sur des atomes ou molécules formant la résine pour les retirer de la couche de résine, cette action mécanique étant éventuellement associée à une réaction chimique. Grâce à cela, on évite les multiples étapes consistant à enlever complètement la résine de la couche, à déposer une deuxième couche de résine et à réaliser une ouverture ou cavité dans cette deuxième couche par photolithographie. Ainsi, d'une part, l'étape d'ablation de la résine est nettement plus courte que dans le cas d'une ablation complète et, d'autre part, le procédé est globalement moins long puisqu'on évite le dépôt d'une deuxième couche.

Dans une première variante de réalisation, l'ablation partielle s'effectue par gravure plasma.

Dans une deuxième variante de réalisation, l'ablation partielle s'effectue par laser.

Avantageusement, la cavité est délimitée, au fond, par le substrat ou par une couche conductrice. Selon l'invention, la cavité est délimitée latéralement par au moins un flanc du métal déposé, et est caractérisé en ce que la couche initiale de résine définissant un premier niveau, il est prévu une étape de dépôt d'une deuxième couche de résine photosensible, lors de laquelle on remplit la cavité et on recouvre le premier niveau, la deuxième couche définissant un deuxième niveau au-dessus du premier niveau.

En gardant de la résine de la couche initiale sur une grande partie du substrat, on conserve une surface quasiment plane avant le dépôt de la deuxième couche de résine. En effet, les seuls reliefs sont les cavités formées dans le premier niveau par ablation de résine. Le dépôt de la deuxième couche est ainsi grandement facilité et l'homogénéité et l'épaisseur de cette deuxième couche sont mieux maîtrisées. En outre, le procédé selon l'invention est caractérisé en ce qu'il comprend une étape d'obtention d'un nouveau moule par photolithographie ou lithographie par faisceau d'électrons et développement de la deuxième couche de résine, le nouveau moule comportant au moins une partie la cavité du premier niveau et une ouverture ménagée dans la résine du deuxième niveau, et une étape de dépôt d'un métal, notamment par électrodéposition, dans le nouveau moule.

Grâce à cela, on fait croître une deuxième partie métallique à partir du fond de la cavité par une deuxième étape de dépôt de métal. Cette deuxième partie métallique est intimement liée et ancrée à la première partie métallique, ce qui assure la robustesse de l'ensemble.

On réalise ainsi un composant métallique comportant deux parties, haute et basse, imbriquées l'une dans l'autre, la partie haute étant ancrée dans la partie basse par le métal déposé dans la cavité du premier niveau. L'imbrication des niveaux successifs rend le composant très robuste notamment vis-à-vis d'efforts de cisaillement.

L'ablation partielle de résine peut être réalisée à l'aide d'un masque. Le masque peut être un masque physique, par exemple en silicium, que l'on dépose sur le premier niveau ou que l'on place juste au-dessus de celui-ci. Le masque ménage des ouvertures correspondant aux zones de résine à enlever. En variante, il peut s'agir d'une couche métallique structurée. L'ablation peut être réalisée par exemple par plasma à travers le masque. En variante, l'ablation partielle peut être réalisée par laser, ou par un solvant déposé de façon très locale.

Le procédé peut aussi comprendre une étape d'ajout d'un insert dans au moins une partie de la cavité suivie d'une étape de croissance d'une couche métallique apte à solidariser l'insert au composant L'ablation sélective peut ainsi être utilisée pour former une cavité dans laquelle un insert est placé ou chassé. Cet insert peut ultérieurement être solidarisé au composant par la croissance d'une couche métallique sur un niveau supplémentaire. Cet insert peut être en matériau métallique ou conducteur, ou en matériau isolant comme le rubis, le Silicium ou la céramique.

Le composant métallique peut être un composant horloger, notamment l'un des éléments du groupe comportant un sautoir, une ancre, une roue, un ressort, un balancier, une came ou un pont.

L'invention sera mieux comprise à l'aide de la description suivante du procédé de fabrication d'un composant métallique selon un mode de réalisation particulier de l'invention et du procédé de traitement d'une couche de résine photosensible, en référence aux dessins annexés sur lesquels :

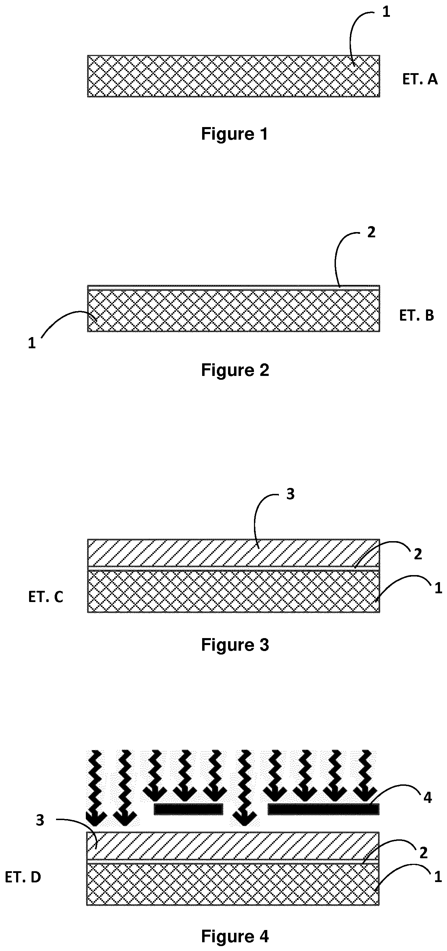

- les figures 1 à 12 représentent les étapes A à K successives du procédé de fabrication du composant métallique, selon un premier mode de réalisation.

Le procédé comprend une étape A (figure 1) de se munir d'un substrat 1. Ce substrat peut être constitué par une plaquette métallique, notamment en alliage comme l'acier inoxydable, ou une plaquette de silicium, de verre ou de céramique. Ce substrat est préparé selon les règles connues de l'homme de l'art, notamment pour son dégraissage, nettoyage, éventuellement passivation et/ou activation. Ce substrat peut être plan ou non, et peut comporter des motifs, notamment des motifs usinés, et/ou des cavités, et/ou d'autres structures, selon les enseignements de l'art antérieur.

Le procédé comprend ensuite optionnellement une étape B (figure 2) de dépôt d'une couche conductrice 2 sur le substrat 1, par exemple par évaporation. Cette couche conductrice 2 est destinée à jouer le rôle de cathode pour l'amorçage d'un dépôt galvanique, ou électrodéposition, ultérieur, notamment dans le cas d'un substrat non conducteur. De façon connue, cette couche conductrice d'amorçage peut comprendre une sous-couche de chrome ou de titane recouverte d'une couche d'or ou de cuivre.

L'étape suivante C (figure 3) consiste à recouvrir la couche conductrice 2 d'une couche initiale de résine photosensible 3 sur une épaisseur souhaitée. Cette épaisseur est préférentiellement supérieure à 0 et inférieure ou égale à 1.5mm. La résine est une résine photosensible, adaptée à la photolithographie. La résine peut être négative ou positive. Dans le premier cas, elle est conçue pour devenir insoluble ou difficilement soluble à un révélateur sous l'action d'un rayonnement, alors que, dans le second cas, elle est conçue pour devenir soluble à un révélateur sous l'action d'un rayonnement, alors que la partie non exposée au rayonnement reste insoluble ou difficilement soluble. Dans l'exemple particulier de la description, la résine utilisée est de type « SU-8 », qui est une résine photosensible négative qui polymérise sous l'action d'un rayonnement UV, par exemple la résine SU-8-100 de la maison Microchem. Cette couche initiale de résine 3 définit un premier niveau N1.

L'étape suivante D (figure 4) est une étape de photolithographie de la couche initiale de résine 3.

L'étape de photolithographie consiste à exposer à une radiation lumineuse ou insoler la couche initiale de résine 3 à travers un masque 4 comprenant des ouvertures et des zones opaques. Ce masque 4 définit le motif à reproduire pour la réalisation du premier niveau du composant à fabriquer. Les radiations lumineuses utilisées pour irradier, ou insoler, la résine sont ici des rayonnements UV émis par une source UV. On pourrait toutefois envisager d'utiliser des rayons X, un faisceau d'électrons (on parle alors de lithographie par faisceau d'électrons) ou tout autre type de radiations selon la résine utilisée. Les rayonnements sont perpendiculaires au plan dans lequel s'étend le masque 4 de manière à n'irradier que les zones de la résine situées au droit des ouvertures ménagées dans le masque 4. Dans l'exemple de réalisation particulier décrit ici, les zones de résine insolées deviennent insensibles ou insolubles à la plupart des liquides de développement.

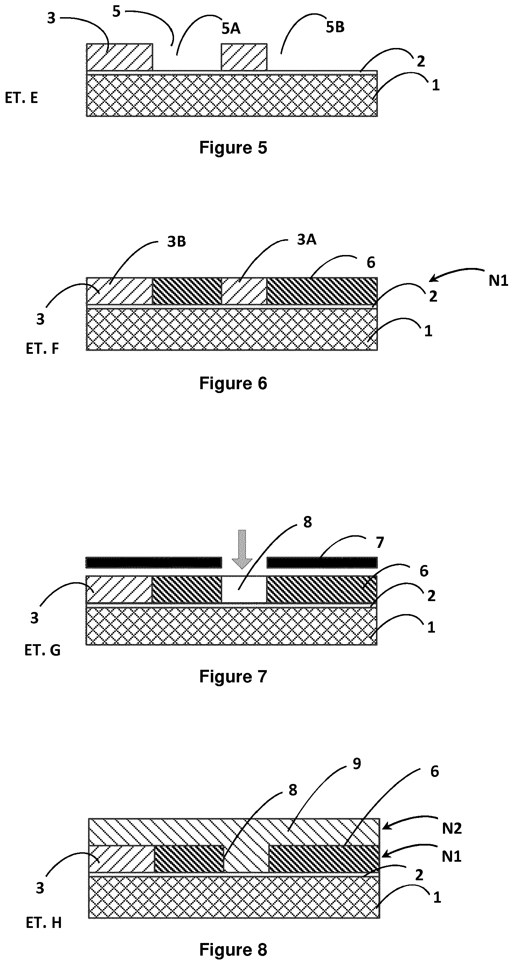

L'étape D d'exposition à des radiations lumineuses (ou à un faisceau d'électrons) est suivie d'une étape de développement E (figure 5). Le développement consiste à éliminer les zones de résine non exposées selon un procédé adapté à la résine utilisée, par exemple par dissolution avec un produit chimique ou par un procédé plasma. Après dissolution, la couche conductrice 2 apparaît aux endroits où la résine a été éliminée. Dans le cas d'une résine photosensible positive, les zones insolées seraient éliminées par exemple par voie chimique et les zones non insolées seraient conservées sur le substrat.

Les parties restantes de résine de la couche initiale 3, référencées 3A et 3B sur les figures, forment un premier moule 5 en résine de premier niveau. Dans l'exemple particulier décrit ici, le moule 5 comporte deux cavités 5A et 5B, représentées sur la figure 4. Le fond de chaque cavité de moule 5A (5B) est délimité par la couche conductrice 2. A l'issue de l'étape de développement E, on obtient donc le moule 5.

L'étape suivante F (figure 6) du procédé consiste à déposer une première couche métallique 6 dans les cavités 5A, 5B du moule 5, par électrodéposition, ou dépôt galvanique, la couche conductrice 2 ou le substrat 1 jouant le rôle de cathode pour amorcer le dépôt. Cette étape utilise par exemple un procédé LiGA et un métal tel que, par exemple, le nickel (Ni) ou le nickel-phosphore (NiP). La couche métallique 6 a préférentiellement la même épaisseur que celle de la couche initiale de résine 3. De façon optionnelle, l'étape F peut être suivie d'une mise d'épaisseur, par polissage mécanique de la couche métallique et de la résine restante.

Le procédé comprend ensuite une étape G (figure 7) d'ablation partielle de la résine de la couche initiale 3. Cette résine restante de la couche initiale 3 se trouve dans un état où elle est insensible ou insoluble à un révélateur, c'est-à-dire qu'elle a subi l'action d'un rayonnement pour une résine négative ou au contraire qu'elle n'a pas subi l'action d'un rayonnement pour une résine positive. Cette étape G consiste à enlever, de façon localisée et sélective, seulement une partie de la résine restante de la couche initiale 3, ici la partie 3A, pour laisser sur le substrat une partie de la résine de la couche initiale, ici la partie 3B, la première couche métallique 6, et une cavité 8 correspondant à la partie de résine enlevée. On soulignera que l'ablation partielle de résine est subséquente à la photolithographie (ou lithographie par faisceau d'électrons) de la couche de résine photosensible 3 et au développement. L'ablation est donc réalisée sur de la résine déjà lithographiée. Dans le mode de réalisation particulier décrit ici, l'ablation sélective est réalisée au travers d'un masque 7 ménageant une ouverture dont la taille et la forme sont adaptées à la partie 3A à enlever. Le masque 7 est un masque dur ou physique, par exemple un masque en silicium. Ce masque peut être réalisé en se munissant d'une plaquette de silicium et en réalisant des ouvertures au travers de la plaquette aux zones correspondant à la résine à enlever. Le masque est ensuite aligné et posé sur la structure, ou maintenu juste au-dessus de celle-ci. En variante, à la place d'un masque physique, on pourrait réaliser un masquage par le dépôt d'une couche métallique structurée.

L'ablation partielle de la résine est réalisée par voie physicochimique ou physique, par exemple par une technique de gravure plasma. Une telle gravure peut être avantageusement réalisée avec un équipement tel que le « Plasma System 210 » de la maison PVA TePla. On rappelle ici que par «voie physicochimique », on entend désigner une technique d'ablation de la résine qui met en jeu une action mécanique agissant sur des atomes ou molécules formant la résine pour les retirer de la couche de résine, cette action mécanique étant éventuellement associée à une réaction chimique. En variante, l'ablation partielle de la résine pourrait être réalisée par laser ou par toute autre technique permettant de retirer localement de la résine. On pourrait également envisager d'enlever une partie de la résine, de façon localisée et sélective, après photolithographie et développement, par voie chimique. La cavité 8 obtenue est délimitée au fond par la couche conductrice 2 et latéralement par des flancs de la couche métallique 6.

Le procédé comprend ensuite une étape H (figure 8) de dépôt d'une deuxième couche de résine, dans cet exemple à nouveau une couche de résine photosensible négative SU-8, référencée 9. Cette deuxième couche 9 est déposée de manière à remplir la cavité 8 et à recouvrir le premier niveau N1 (c'est-à-dire la résine restante 3A de la couche initiale 3 et la couche métallique 6). Elle définit un deuxième niveau N2, s'étendant au-dessus du premier N1. L'épaisseur du deuxième niveau N2 est avantageusement strictement supérieure à 0 et inférieure ou égale à 1,5 mm.

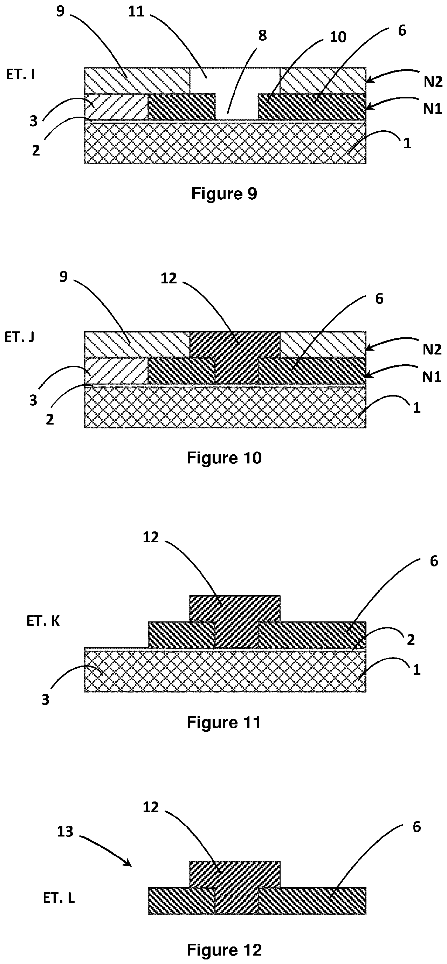

L'étape suivante I (figure 9) est une étape d'obtention d'un deuxième moule par photolithographie de la deuxième couche de résine 9. Elle comporte des étapes de photolithographie et de développement, analogues à celles des étapes D et E. Cette étape I conduit à enlever la résine contenue dans la cavité 8 et à réaliser une ouverture dans la résine du deuxième niveau N2, située au droit de la cavité 8 et s'étendant latéralement sur une partie de la couche métallique 6. Un deuxième moule 10 à deux niveaux est ainsi produit. Il comporte, au premier niveau, la cavité 8 et, au deuxième niveau, l'ouverture 11. La couche conductrice 2 apparaît au fond du moule 10. Bien entendu, il est possible d'enlever la résine sur une partie de la cavité 8 seulement, de façon à ce que le deuxième moule comporte, au premier niveau, une partie de la cavité 8 limitée d'une part par un flanc latéral de la couche métallique 6 et d'autre part par un flanc latéral de résine. Alternativement, le deuxième moule peut aussi comporter, au premier niveau, une partie de la cavité 8 limitée par deux flancs latéraux distincts de résine. En variante, le deuxième moule peut comporter tout ou partie de la cavité 8 du premier niveau.

Le procédé comprend ensuite une étape d'électrodéposition J (figure 10), ou de dépôt galvanique, consistant à déposer une deuxième couche métallique 12 dans le moule 10. Cette étape J est analogue à l'étape F de dépôt de la première couche métallique. L'épaisseur de la deuxième couche métallique 12 est préférentiellement égale à celle du niveau N2 (c'est-à-dire à l'épaisseur de la partie de la deuxième couche de résine s'étendant au-dessus du niveau N1, sur le niveau N2). L'électrodéposition de la deuxième couche métallique est ici amorcée par la couche conductrice 2 recouvrant le substrat 1. En variante, elle pourrait être amorcée par le substrat, dans le cas où celui-ci est conducteur, et/ou du métal déposé du premier niveau. De façon optionnelle, l'étape J peut être suivie d'une mise d'épaisseur, par polissage mécanique de la couche métallique et de la résine.

Lors des deux dernières étapes K (figure 11) et L (figure 12), la résine restante des niveaux N1 et N2 est enlevée (ou « strippée »), par exemple par un traitement plasma ou par voie chimique, et le substrat 1 est retiré également par voie chimique, par exemple par dissolution chimique de la couche conductrice. L'étape L peut être réalisée indifféremment après ou avant l'étape K. Alternativement, la résine restante des niveaux N1 et N2 et les composants réalisés par électrodéposition sont détachés du substrat avant élimination de la résine. Optionnellement, des opérations de reprise ou d'usinage ou de modification de surface, comme le dépôt d'un revêtement, peuvent être effectués sur les composants électrodéposés, que ce soit avant ou après détachage du substrat et/ou avant ou après élimination de la résine.

Le composant métallique obtenu 13 comprend au moins deux niveaux, premier et deuxième, le deuxième niveau étant imbriqué dans le premier.

Le composant métallique obtenu 13 comprend au moins deux parties respectivement réalisées lors d'étapes d'électroformage distinctes, la deuxième partie étant imbriquée dans la première. La première partie peut être déposée directement sur le substrat ou sur un dépôt ou couche ou partie déposée par électroformage. De même, un dépôt ou couche ou partie additionnelle peut être réalisé(e) par électroformage sur la deuxième partie. Les deux parties peuvent être réalisées dans le même matériau ou dans des matériaux différents. Une couche, par exemple une couche conductrice ou une couche d'accroche, peut être intercalée entre les deux parties.

L'ablation partielle de la résine, réalisée lors de l'étape G, présente de multiples avantages :
- le temps de traitement pour une ablation partielle de la résine est beaucoup plus court que pour une ablation complète ;
- l'ablation partielle permet de réaliser directement la cavité souhaitée, sans passer par plusieurs étapes d'enlèvement complet de la résine de la couche initiale, de dépôt d'une deuxième couche de résine au premier niveau et de réalisation d'une cavité par lithographie de la deuxième couche de résine. Le nombre d'étapes de procédé est ainsi réduit, ce qui a pour effet de diminuer globalement le temps de fabrication ;
- l'ablation partielle de la résine de la couche initiale garantit un bon maintien de la couche métallique préalablement déposée sur le substrat grâce à l'action de maintien de la résine restante de la couche initiale. On évite ainsi le risque d'un décollement de la couche métallique déposée ;
- le substrat demeure également protégé par la résine restante de la couche initiale tout au long du procédé de fabrication, ce qui diminue fortement les contraintes liées au maintien de la propreté du substrat pendant le procédé de fabrication.

Dans le cas de la fabrication d'un composant multi-niveaux, en particulier d'un composant avec trois niveaux ou plus, on pourrait envisager de mettre en oeuvre une étape d'ablation partielle de résine à tout niveau du composant en cours de fabrication.

En toute hypothèse, l'ablation partielle consiste à enlever localement et de façon sélective une partie de la résine de la structure, préférentiellement jusqu'à faire apparaître une partie du substrat ou de la surface d'un niveau inférieur de métal électrodéposé, une partie d'une couche conductrice recouvrant le substrat ou la surface d'un niveau inférieur de métal électrodéposé ou de résine. En alternative, seule une partie de l'épaisseur de la résine peut être enlevée localement. Dans ce cas, une couche conductrice devrait être déposée, par exemple par un procédé de type PVD, si une croissance subséquente est envisagée.

Cette ablation partielle est de préférence réalisée par voie physico-chimique.

L'ablation partielle, ou sélective, peut également être utilisée pour réaliser une cavité dans la résine et ajouter ou chasser un insert dans tout ou partie de cette cavité. Cet insert pourrait ensuite être solidarisé au composant en cours de fabrication par la croissance d'une couche métallique supplémentaire.

D'une manière plus générale encore, l'ablation partielle et sélective de résine peut être utilisée
- pour traiter une couche de résine photosensible, qui peut être posée sur un substrat en acier, en silicium ou autre, le traitement consistant à réaliser une ouverture dans la couche de résine, par exemple par voie physico-chimique (gravure plasma par exemple), de manière analogue à ce qui a été décrit dans le cadre du procédé de fabrication d'un composant métallique;
- pour traiter une couche de résine photosensible, suite à des étapes de photolithographie (ou de lithographie par électrons) et de développement de celle-ci, le traitement consistant à enlever de façon localisée et sélective une partie de la résine ayant subi des opérations de photolithographie et de développement.

Le procédé précédemment décrit de fabrication d'un composant métallique peut être utilisé pour la fabrication de composants horlogers tels que, à titre d'exemples illustratifs et non limitatifs, une ancre, un sautoir, une roue, un ressort, un balancier, une came ou encore un pont.

## Revendications

1. Procédé de fabrication d'un composant métallique, comprenant les étapes de :
• dépôt (C) d'une couche initiale de résine photosensible (3) sur un substrat (1);
• photolithographie ou lithographie aux électrons de la couche initiale de résine (3);
• développement (E) de la couche initiale de résine et obtention d'un moule (5);
• dépôt (F), notamment par électrodéposition, d'un métal (6) ou d'un alliage, dans le moule (5) ;
**caractérisé par le fait que** l'étape (F) de dépôt d'un métal (6) ou alliage est suivie d'une étape (G) d'ablation partielle de résine de la couche initiale (3), afin de former une cavité (8) délimitée latéralement par au moins un flanc du métal déposé (6), et **caractérisé en ce que**, la couche initiale de résine (3) définissant un premier niveau, il est prévu une étape de dépôt d'une deuxième couche de résine photosensible (9), lors de laquelle on remplit la cavité (8) et on recouvre le premier niveau (3), la deuxième couche (9) définissant un deuxième niveau au-dessus du premier niveau, et **caractérisé en ce que** le procédé comprend :
• une étape (I) d'obtention d'un nouveau moule (10, 8, 11) par photolithographie ou lithographie par faisceau d'électrons et développement de la deuxième couche de résine (9), le nouveau moule (10) comportant au moins une partie de la cavité (8) du premier niveau (3) et une ouverture (11) ménagée dans la résine du deuxième niveau (9), et
• une étape (J) de dépôt d'un métal (12), notamment par électrodéposition, dans le nouveau moule (10).

2. Procédé selon la revendication 1, **caractérisé en ce que** l'ablation partielle (G) s'effectue par voie physique ou physicochimique.

3. Procédé selon la revendication 1 ou 2, **caractérisé en ce que** l'ablation partielle (G) s'effectue par gravure plasma.

4. Procédé selon la revendication 1 ou 2, **caractérisé en ce que** l'ablation partielle s'effectue par laser.

5. Procédé selon l'une des revendications 1 à 4, **caractérisé en ce que** la cavité (8) est délimitée, au fond, par le substrat ou par une couche conductrice (2).

6. Procédé selon l'une des revendications 1 à 5, **caractérisé en ce que** l'ablation partielle (G) est réalisée au travers d'un masque physique (7) ménageant une ouverture correspondant à une zone de résine à enlever.

7. Procédé selon la revendication précédente, **caractérisé en ce que** le masque (7) est en silicium.

8. Procédé selon l'une des revendications 1 à 7, **caractérisé en ce qu'**il est prévu une étape d'ajout d'un insert dans au moins une partie de la cavité suivie d'une étape de croissance d'une couche métallique apte à solidariser l'insert au composant.

9. Procédé selon l'une des revendications 1 à 8, **caractérisé en ce que** le composant métallique est un composant horloger, notamment l'un des éléments du groupe comportant un sautoir, une ancre, une roue, un ressort, un balancier, une came ou encore un pont.

## Patentansprüche

1. Verfahren zur Herstellung eines Metallbauteils, umfassend die folgenden Schritte:
- Aufbringen (C) einer Initialschicht aus lichtempfindlichem Harz (3) auf ein Substrat (1);
- Fotolithographie oder Lithographie der Elektronen der initialen Harzschicht (3);
- Entwicklung (E) der initialen Harzschicht und Erhalt einer Form (5);
- Aufbringen (F), insbesondere durch galvanische Beschichtung, eines Metalls (6) oder einer Legierung in die Form (5);
**dadurch gekennzeichnet, dass**
auf den Schritt (F) zum Aufbringen eines Metalls (6) oder einer Legierung ein Schritt (G) folgt zur teilweisen Entfernung des Harzes der Initialschicht (3), um eine Aussparung (8) zu bilden, die seitlich durch mindestens eine Flanke des aufgebrachten Metalls (6) begrenzt ist und **dadurch gekennzeichnet, dass**
die Initialschicht aus Harz (3) eine erste Ebene bildet, ein Schritt zum Aufbringen einer zweiten Schicht lichtempfindlichen Harzes (9) vorgesehen ist, während dessen die Aussparung (8) gefüllt wird und die erste Ebene (3) bedeckt wird, wobei die zweite Schicht (9) eine zweite Ebene über der ersten Ebene darstellt, und
**dadurch gekennzeichnet, dass** das Verfahren umfasst:
- einen Schritt (I) zum Erhalt einer neuen Form (10, 8, 11) durch Fotolithographie oder Elektronenstrahl-Lithographie und Entwicklung der zweiten Harzschicht (9), wobei die neue Form (10) mindestens einen Teil der Aussparung (8) der erste Ebene umfasst und eine Öffnung (11), die im Harz der zweiten Ebene (9) vorgesehen ist, und
- einen Schritt (J) zum Aufbringen eines Metalls (12), insbesondere durch galvanische Beschichtung, in der neuen Form (10).

2. Verfahren gemäß Anspruch 1, **dadurch gekennzeichnet, dass** das teilweise Entfernen (G) physikalisch oder physikochemisch erfolgt.

3. Verfahren gemäß einem der Ansprüche 1 oder 2, **dadurch gekennzeichnet, dass** das teilweise Entfernen (G) mittels Plasma-Ätzen erfolgt.

4. Verfahren gemäß einem der Ansprüche 1 oder 2, **dadurch gekennzeichnet, dass** das teilweise Entfernen (G) mittels Laser erfolgt.

5. Verfahren gemäß einem der Ansprüche 1 bis 4, **dadurch gekennzeichnet, dass** die Aussparung (8) am Boden begrenzt ist durch das Substrat oder durch eine leitende Schicht (2).

6. Verfahren gemäß einem der Ansprüche 1 bis 5, **dadurch gekennzeichnet, dass** das teilweise Entfernen (G) durch eine physikalische Maske (7) hindurch vorgenommen wird, die eine Öffnung aufweist, die einem im Harz zu entfernenden Bereich entspricht.

7. Verfahren gemäß dem vorangehenden Anspruch, **dadurch gekennzeichnet, dass** die Maske (7) aus Silizium besteht.

8. Verfahren gemäß einem der Ansprüche 1 bis 7, **dadurch gekennzeichnet, dass** ein Schritt des Hinzufügens eines Einsatzes in wenigstens einen Teil der Aussparung vorgesehen ist, auf den ein Schritt zum Aufwachsen einer metallischen Schicht folgt, welche dazu geeignet ist, den Einsatz am Bauteil zu befestigen.

9. Verfahren gemäß einem der Ansprüche 1 bis 8, **dadurch gekennzeichnet, dass** das Metallbauteil ein Uhrenbauteil ist, insbesondere eines der Elemente der Gruppe umfassend eine Sperre, einen Anker, ein Rad, eine Feder, eine Unruh, einen Nocken oder eine Brücke.

## Claims

1. Process for manufacturing a metal component, comprising steps of:
• depositing (C) an initial photoresist layer (3) on a substrate (1);
• photolithography or electron-beam lithography of the initial resist layer (3);
• developing (E) the initial resist layer and obtaining a mould (5);
• depositing (F), in particular by electrodeposition, a metal (6) or an alloy, in the mould (5);
**characterized in that** the step (F) of depositing a metal (6) or alloy is followed by a step (G) of partially ablating the resist of the initial layer (3), in order to form a cavity (8) that is bounded laterally by at least one flank of the deposited metal (6), and **characterized in that**, the initial resist layer (3) defining a first level, provision is made for a step of depositing a second photoresist layer (9), in which step the cavity (8) is filled and the first level (3) is covered, the second layer (9) defining a second level above the first level, and **characterized in that** the process comprises:
• a step (I) of obtaining a new mould (10, 8, 11) by photolithography or electron-beam lithography and development of the second resist layer (9), the new mould (10) including at least one portion of the cavity (8) of the first level (3) and an aperture (11) in the resist of the second level (9), and
• a step (J) of depositing a metal (12), in particular by electrodeposition, in the new mould (10).

2. Process according to Claim 1, **characterized in that** the partial ablation (G) is achieved by physical or physico-chemical processing.

3. Process according to Claim 1 or 2, **characterized in that** the partial ablation (G) is achieved by plasma etching.

4. Process according to Claim 1 or 2, **characterized in that** the partial ablation is achieved by laser.

5. Process according to one of Claims 1 to 4, **characterized in that** the cavity (8) is bounded, at the bottom, by the substrate or by a conductive layer (2).

6. Process according to one of Claims 1 to 5, **characterized in that** the partial ablation (G) is carried out through a physical mask (7) containing an aperture corresponding to a zone of resist to be removed.

7. Process according to the preceding claim, **characterized in that** the mask (7) is made of silicon.

8. Process according to one of Claims 1 to 7, **characterized in that** provision is made for a step of adding an insert to at least one portion of the cavity, followed by a step of growing a metal layer able to securely fasten the insert to the component.

9. Process according to one of Claims 1 to 8, **characterized in that** the metal component is a timepiece component, in particular one of the elements from the group including a jumper, a pallet, a wheel, a spring, a lever, a cam or even a bridge.
